# EUROPEAN PATENT APPLICATION

(11) **EP 4 814 786 A1**
(43) Date of publication of application: **30.09.2026**
(21) Application number: 24863819.9
(22) Date of filing: 19.11.2024
(51) Int. Cl.: G06K 19/077, B44C 3/02, B44C 1/00, H05K 1/11, H05K 3/18

(54) **ELECTRIC CIRCUIT FOR SMART CARD, MANUFACTURING METHOD THEREFOR, AND SMART CARD COMPRISING ELECTRIC CIRCUIT**

(30) Priority: 20.11.2023 KR 20230160281
(71) Applicant: Agencomm Co., Ltd, Busan 49315 (KR)
(72) Inventor: LEE, Jaesoo, Siheung-si Gyeonggi-do 15117 (KR); KANG, Taehyuk, Siheung-si Gyeonggi-do 15117 (KR)
(74) Representative: Casalonga
(86) International application number: PCT/KR2024/018195
(87) International publication number: WO 2025/110661

(57) **Abstract**

Disclosed are an electric circuit for smart card, a manufacturing method thereof, and a smart card including the electric circuit. The disclosed electric circuit for smart card may include a substrate; a first circuit pattern provided on the substrate and including a conductor; and a metallic contact layer formed on the substrate to cover the first circuit pattern, and configured to have at least two types of metallic surface colors exposed to the contact surface of the electric circuit. The metallic contact layer may include a first color layer formed of a first material to have a first color and a second color layer formed of a second material to have a second color different from the first color, and at least a portion of the first color layer and at least a portion of the second color are exposed to the contact surface. The first color layer may be a first plating layer, and the second color layer may be a second plating layer.

## Description

### TECHNICAL FIELD

The present invention relates to an electronic/semiconductor device and an instrument/apparatus that applies the same, and more particularly, to an electric circuit for smart card, a manufacturing method thereof, and a smart card including the electric circuit.

### RELATED ART

A smart card (chip card or integrated circuit card) refers to a plastic card that is embedded with a microprocessor and a memory, and enables storing and processing of information. Smart cards with the same shape and size as those of credit cards are most commonly used. Currently, various types of technologies related to the smart cards are developing very rapidly. In particular, with the advancement of semiconductor and part technology, the processing power and memory capacity of the smart cards are significantly increasing. At the same time, interface functions combinable with the smart card are also greatly improving.

The smart cards may be classified into various types depending on whether a microprocessor is included, an interface method, or a stage of evolution. The smart cards may be used in many ways, from keys people carry to wallets, IDs, and ultimately personal computers. Due to this versatility, the scale of the smart card market is growing at a rapid pace.

However, in the case of an integrated circuit (IC) chip substrate (i.e., electric circuit) applied to the existing smart card, the surface color is standardized or limited to gold color or silver color due to manufacturing method restrictions. Since the color of the surface (contact surface) of the IC chip substrate (i.e., electric circuit) is standardized into a single color, this makes it difficult to advance color or create emotional and design functions/values, and in relation to this, it is difficult to meet the diverse needs of consumers (users). Therefore, technology is required to overcome such problems, to advance the surface color of an electric circuit for smart card, and to implement emotional color/design.

### DETAILED DESCRIPTION

### TECHNICAL SUBJECT

A technical subject to be achieved by the present invention provides an electric circuit for smart card and a manufacturing method thereof that may diversify/advance the color of the metallic contact surface, which has been limited due to the existing technical constraint, into at least two types, may improve aesthetics (visual characteristics) by enabling application of various designs (patterns), and may also easily secure excellent electrical characteristics.

A technical subject to be achieved by the present invention provides an electric circuit for smart card and a manufacturing method thereof that may break away from the monotony of the existing metallic contact surface color and may create an emotional/design added value with two or more types of surface colors.

Also, a technical subject to be achieved by the present invention provides a smart card including the aforementioned electric circuit.

Subjects to be solved by the present invention are not limited to the aforementioned subjects and still other subjects not described herein may be clearly understood by one of ordinary skill in the art from the following description.

### TECHNICAL SOLUTION

According to example embodiments of the present invention to accomplish the aforementioned subjects, there is provided an electric circuit for smart card, including a substrate; a first circuit pattern provided on the substrate and including a conductor; and a metallic contact layer formed on the substrate to cover the first circuit pattern, and configured to have at least two types of metallic surface colors exposed to the contact surface of the electric circuit, wherein the metallic contact layer includes a first color layer formed of a first material to have a first color and a second color layer formed of a second material to have a second color different from the first color, and at least a portion of the first color layer and at least a portion of the second color layer are exposed to the contact surface.

### EFFECT

According to example embodiments of the present invention, it is possible to implement an electric circuit for smart card that may diversify/advance the color of the metallic contact surface, which has been limited due to the existing technical constraint, into at least two types, may improve aesthetics (visual characteristics) by enabling application of various designs (patterns), and may also easily secure excellent electrical characteristics. According to example embodiments, it is possible to implement an electric circuit for smart card that may break away from the monotony of the existing metallic contact surface color and may create an emotional/design added value with two or more types of surface colors.

When applying the electric circuit for smart card according to such example embodiments, it is possible to manufacture a smart card that may meet various needs of consumers (users).

However, the effects of the present invention are not limited to the aforementioned effects, and may be variously expanded within the range that does not depart from the technical spirit and area of the present invention.

### BRIEF DESCRIPTION OF DRAWINGS

FIG. 1 is a cross-sectional view illustrating an electric circuit for smart card according to an example embodiment of the present invention.
FIG. 2 is a photo image showing the contact surface of an electric circuit for smart card according to an example embodiment of the present invention.
FIG. 3 is a photo image showing the contact surface of an electric circuit for smart card according to various example embodiments of the present invention.
FIG. 4 is a photo image showing the contact surface of an electric circuit according to a comparative example.
FIG. 5 is an image showing a smart card that applies an electric circuit for smart card according to an example embodiment of the present invention.
FIGS. 6 to 11 are cross-sectional views for describing a manufacturing method of an electric circuit for smart card according to an exemplary example embodiment of the present invention.
FIG. 12 illustrates a view for describing a manufacturing method of an electric circuit for smart card according to an exemplary example embodiment of the present invention.
FIG. 13 illustrates a view for describing a manufacturing method of an electric circuit for smart card according to an example embodiment of the present invention.

### BEST MODE

According to example embodiments of the present invention to accomplish the aforementioned subjects, there is provided an electric circuit for smart card, including a substrate; a first circuit pattern provided on the substrate and including a conductor; and a metallic contact layer formed on the substrate to cover the first circuit pattern, and configured to have at least two types of metallic surface colors exposed to the contact surface of the electric circuit, wherein the metallic contact layer includes a first color layer formed of a first material to have a first color and a second color layer formed of a second material to have a second color different from the first color, and at least a portion of the first color layer and at least a portion of the second color layer are exposed to the contact surface.

The first color layer may be a first plating layer, and the second color layer may be a second plating layer.

The first color layer may include one of Au, Pd, Ag, and Ni, and the second color layer may include another one of Au, Pd, Ag, and Ni.

A plurality of contact pad areas may be defined on the contact surface of the electric circuit, and at least two of the plurality of contact pad areas may have different metallic surface colors, or different metallic surface colors may be applied within one contact pad area among the plurality of contact pad areas.

A plurality of contact pad areas and a pattern area may be defined on the contact surface of the electric circuit, the pattern area may include at least one of a character, a number, a symbol, and a picture design, and the at least two types of metallic surface colors may be applied to at least one of the plurality of contact pad areas and the pattern area.

The plurality of contact pad areas may be provided to surround the pattern area.

A portion of the first color layer may be covered by the second color layer and may not be exposed to the contact surface.

The first circuit pattern may be in at least one structure of a Cu/Ni/Au stacked structure, a Cu/Ni/Au/Pd stacked structure, a Cu/Ni/Pd/Au stacked structure, a Cu/Ni/Pd stacked structure, a Cu/Pd stacked structure, a Cu/Ni stacked structure, a Cu/Au stacked structure, and a Cu single layer structure.

The first circuit pattern may be provided on a first surface of the substrate, and the electric circuit for smart card may further include a second circuit pattern provided on a second surface of the substrate; and a plating layer formed on the second surface of the substrate to cover the second circuit pattern.

According to other example embodiments of the present invention, there is provided a smart card including the aforementioned electric circuit for smart card.

According to other example embodiments of the present invention, there is provided a manufacturing method of an electric circuit for smart card, including preparing a device structure for the electric circuit provided with a first circuit pattern that includes a conductor on a substrate; and forming a metallic contact layer on the substrate to cover the first circuit pattern, and having at least two types of metallic surface colors exposed to the contact surface of the electric circuit, wherein the metallic contact layer is configured to include a first color layer formed of a first material to have a first color and a second color layer formed of a second material to have a second color different from the first color, and at least a portion of the first color and at least a portion of the second color are exposed to the contact surface.

The first color layer may be a first plating layer, and the second color layer may be a second plating layer.

The first color layer may include one of Au, Pd, Ag, and Ni, and the second color layer may include the other one of Au, Pd, Ag, and Ni.

The forming of the metallic contact layer may include forming the first color layer on the substrate to cover the first circuit pattern using a plating method; forming a mask material layer on the substrate to cover the first color layer; forming a mask pattern with an opening that exposes a portion of the first color layer from the mask material layer by removing a portion of the mask material layer; forming the second color layer on the first color layer exposed by the opening using a plating method; and removing the mask pattern.

The manufacturing method of the electric circuit for smart card may further include pressing the mask material layer after forming the mask material layer.

A portion of the first color layer may be covered by the second color layer, and may not be exposed to the contact surface.

The first circuit pattern may be provided on a first surface of the substrate, and the device structure may further include a second circuit pattern provided on a second surface of the substrate, and the manufacturing method of the electric circuit for smart card may further include forming a plating layer on the second surface of the substrate to cover the second circuit pattern.

### MODE

Hereinafter, example embodiments of the present invention are described in detail with reference to the accompanying drawings.

The example embodiments of the present invention to be described below are provided to more clearly explain the present invention for one of ordinary skill in the art, and the scope of the present invention is not limited to the example embodiments and the following example embodiments may be modified in various forms.

The terms used herein are used to explain a specific example embodiment and is not construed to limit the present invention. The singular forms used herein are intended to include the plural forms as well, unless the context clearly indicates otherwise. Also, the terms "comprise" and/or "comprising," when used in this specification, specify the presence of stated features, steps, integers, operations, components, elements and/or groups thereof, but do not preclude the presence or addition of one or more other features, steps, integers, operations, components, elements and/or groups thereof. Also, the term "connect" used in this specification represents that some components are directly connected and also includes that still another component is further provided between components and indirectly connected.

In addition, when it is described that a component is located "on" another component, it includes a case in which still another component is present between two components as well as a case in which a component is in contact with the other component. As used herein, the term "and/or" includes any one and any combination of any two or more of the listed items. Also, the terms of degree, such as "about" and "substantially," used herein are used to indicate a range or close to a value or degree, in consideration of unique manufacturing and material tolerances, and are used to prevent infringers from unfairly using the disclosure in which precise or absolute numerical values are provided to help understanding of the present application.

Hereinafter, the example embodiments of the present invention are described in detail with reference to the accompanying drawings. Sizes or thickness of areas or parts illustrated in the drawings may be somewhat exaggerated for clarity of the specification and convenience of description. Like reference numerals refer to like components throughout.

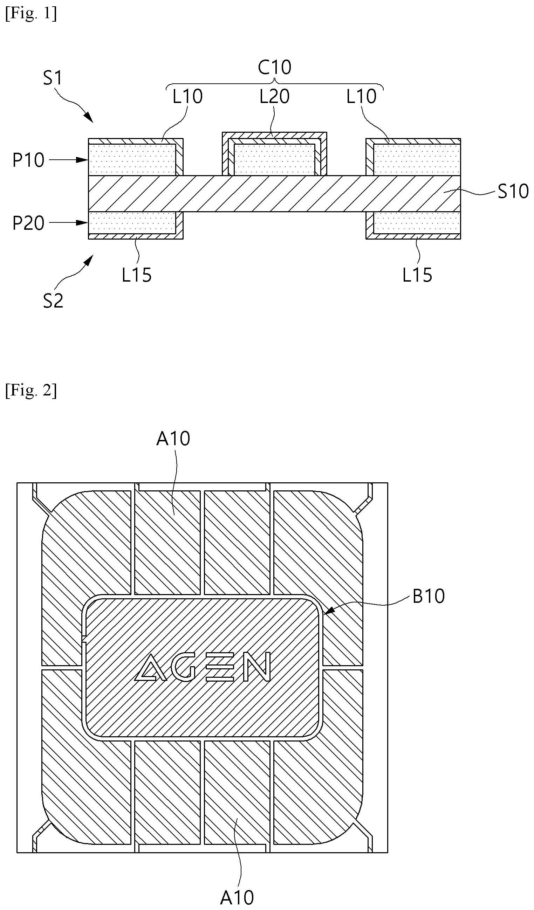

FIG. 1 is a cross-sectional view illustrating an electric circuit for smart card according to an example embodiment of the present invention. A structure shown in FIG. 1 may be an integrated circuit (IC) chip substrate structure (i.e., electric circuit substrate), and an IC chip (not shown) may be bonded on the bonding surface (i.e., S2) of the IC chip substrate structure.

Referring to FIG. 1, the electric circuit for smart card according to an example embodiment of the present invention may include a substrate S10 and a first circuit pattern P10 provided on the substrate S10. The substrate S10 may be an insulating substrate. Also, the substrate S10 may be a flexible substrate. The substrate S10 may include polymer or may be configured with polymer. For example, the substrate S10 may include epoxy or may be configured with epoxy. However, a material of the substrate S10 is not limited to epoxy and may be variously changed. In the case of using the substrate S10 with a flexible characteristic, the electric circuit may have a flexible characteristic.

The first circuit pattern P10 may include a conductor or may be formed as a conductor. The first circuit pattern P10 may be formed on a first surface (one of top and bottom surfaces) of the substrate S10. Here, for convenience, the first circuit pattern P10 is simply illustrated, but the actual first circuit pattern P10 may have a more complex structure than that shown here. The first circuit pattern P10 may include a plurality of pattern portions spaced apart from each other, and the surface of the substrate S10 may be exposed between the plurality of portions. The first circuit pattern P10 may have a stacked structure in which a plurality of conductive layers are stacked. For example, the first circuit pattern P10 may have at least one structure among a Cu/Ni/Au stacked structure, a Cu/Ni/Au/Pd stacked structure, a Cu/Ni/Pd/Au stacked structure, a Cu/Ni/Pd stacked structure, a Cu/Pd stacked structure, a Cu/Ni stacked structure, a Cu/Au stacked structure, and a Cu single structure. In the stacked structure, the arrangement order of metal layers is described in a direction away from the substrate S10. For example, in the case of the Cu/Ni/Au stacked structure, it represents a case in which a Cu layer is formed on the substrate S10, an Ni layer is formed on the Cu layer, and an Au layer is formed on the Ni layer.

Although not illustrated in FIG. 1, a predetermined adhesive layer may be further provided between the substrate S10 and the first circuit pattern P10. The adhesive layer may have a patterned structure or a consecutive layer structure. The adhesive layer may have an insulating material and may be regarded as a portion of the substrate S10. That is, the adhesive layer may be regarded to be included in the substrate S10.

The electric circuit for smart card may include a metallic contact layer C10 formed on the substrate S10 to cover the first circuit pattern P10. The metallic contact layer C10 may be configured to have at least two types of metallic surface colors exposed to the contact surface S1 of the electric circuit. The contact surface S1 may be the surface on which the first circuit pattern P10 between both surfaces of the electric circuit.

The metallic contact layer C10 may include a first color layer L10 formed of a first material to have a first color and a second color layer L20 formed of a second material to have a second color different from the first color. The first material may include a metal or a metallic material, and the second material is different from the first material and may include a metal or a metallic material. At least a portion of the first color layer L10 and at least a portion of the second color layer L20 may be exposed to the contact surface S1.

According to an example embodiment, the first color layer L10 may be a first plating layer, and the second color layer L20 may be a second plating layer. The first and second color layers L10 and L20 may be plating layers (metal layers) formed using a plating method. As a non-limiting example, the first color layer L10 may be formed on the surface of the first circuit pattern P10 using a plating method. The second color layer L20 may be formed on a portion of the first color layer L10 using a plating method.

The first and second color layers L10 and L20 may contain different metals. In detail, for example, the first color layer L10 may include one of Au, Pd, Ag, and Ni, the second color layer L20 may include another one of Au, Pd, Ag, and Ni. The first color layer L10 may be formed of one of Au, Pd, Ag, and Ni, and the second color layer L20 may be formed of another one of Au, Pd, Ag, and Ni. Here, Au may produce gold color, and Pd and Ag may produce silver color. However, specific materials of the first and second color layers L10 and L20 are not limited to the above and may variously vary depending on cases. Also, colors expressed by the first and second color layers L10 and L20 may be more diverse than silver color and gold color.

According to an example embodiment, a portion of the first color layer L10 may be covered by the second color layer L20 and may not be exposed to the contact surface S1. In this case, the portion of the first color layer L10 covered by the second color layer L20 may serve as a plating seed to form the second color layer L20. However, example embodiments of the present invention are not limited thereto. That is, the entire first color layer L10 may not be covered by the second color layer L20, and the layers L10 and L20 may be separately formed. In this case, the entire first color layer L10 may be exposed to the contact surface S1, and the entire second color layer L20 may be exposed to the contact surface S1.

Also, according to an example embodiment, the electric circuit for smart card may further include a metallic material layer L15 formed on a second circuit pattern P20 provided on a second surface (one of top and bottom surfaces) of the substrate S10 and the metallic material layer L15 formed on the second surface of the substrate S10 to cover the second circuit pattern P20. The second surface of the substrate S10 may be a surface that faces (opposite to) the first surface. The metallic material layer L15 may be a metallic surface layer. According to an example, the metallic material layer L15 may be a plating layer. As a non-limiting example, the metallic material layer L15 may include one of Au, Pd, Ag, and Ni, or may be formed of one of Au, Pd, Ag, and Ni. The second circuit pattern P20 and the metallic material layer L15 may be provided on a bonding surface S2 of the electric circuit.

The thickness of the first color layer L10, as a non-limiting example, may range from about 0.5 to 45 µm. The thickness of the second color layer L20, as a non-limiting example, may range from about 0.005 to 15 µm. The thickness of the metallic material layer L15, as a non-limiting example, may range from about 0.005 to 15 µm. The first color layer L10, the second color layer L20, and the metallic material layer L15 may have low electrical resistance characteristics required for the electric circuit for smart card.

A cross-sectional structure of the electric circuit for smart card according to an example embodiment shown in FIG. 1 is simplified, partial, and illustrative, and a cross-sectional view of an actual electric circuit may be more complex than that shown in FIG. 1.

FIG. 2 is a photo image showing the contact surface of an electric circuit for smart card according to an example embodiment of the present invention.

Referring to FIG. 2, a plurality of contact pad areas A10 may be defined on the contact surface (S1 of FIG. 1) of the electric circuit for smart card according to an example embodiment. The plurality of contact pad areas A10 may have an array structure of a contact pad for communication. Also, a pattern area B10 may be further defined on the contact surface of the electric circuit for smart card. The pattern area may be configured to include at least one of a character, a number, a symbol, and a picture design. According to an example, the plurality of contact pad areas A10 may be provided to surround the pattern area B10. That is, in a planar image viewed from above, the plurality of contact pad areas A10 may be provided to surround the pattern area B10 in all directions. In this case, aesthetic characteristic and effect may be improved, and functions of the contact surface may be advantageously secured. However, a positional relationship between the plurality of contact pad areas A10 and the pattern area B10 may change without being limited to the above.

According to an example embodiment, the "at least two types of metallic surface colors" described above with FIG. 1 may be applied to at least one of the plurality of contact pad areas A10 and the pattern area B10. The example embodiment of FIG. 2 shows a case in which the contact pad area A10 has the first color and the pattern area B10 has the second color. However, the "at least two types of metallic surface colors" may be applied within the plurality of contact pad areas A10, and/or the "at least two types of metallic surface colors" may be applied within the pattern area B10. In the former case, that is, when the "at least two types of metallic surface colors" are applied within the plurality of contact pad areas A10, at least two of the plurality of contact pad areas A10 may have different metallic surface colors or different metallic surface colors may be applied within one contact pad area among the plurality of contact pad areas A10. It is possible to implement different colors for each contact pad area and to apply different colors without restriction on shape and design even within the same contact pad area. Therefore, diversification and advancement of color and design within the contact surface may be easily realized.

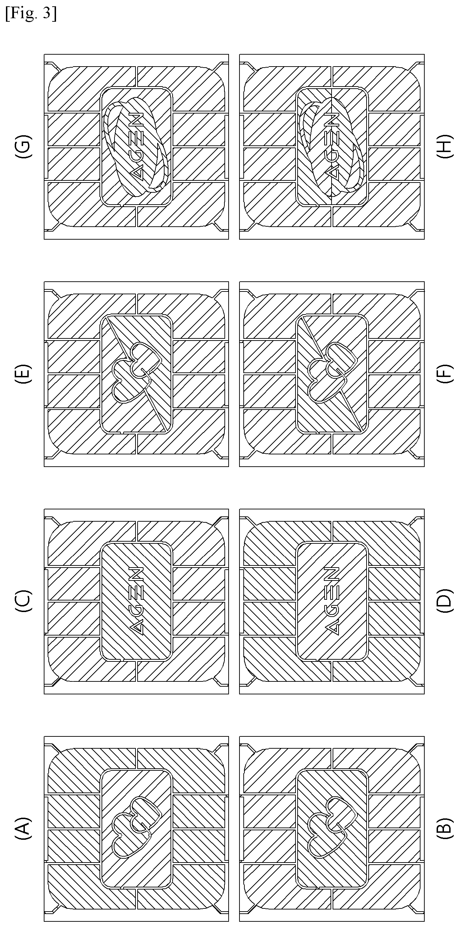

FIG. 3 is a photo image showing the contact surface of an electric circuit for smart card according to various example embodiments of the present invention.

Referring to FIG. 3, the electric circuit for smart card according to an example embodiment of the present invention may have various design and color combinations as shown in (A) to (H). The aforementioned "at least two types of metallic surface colors" may be applied in various manners to at least one of the plurality of contact pad areas and the pattern area.

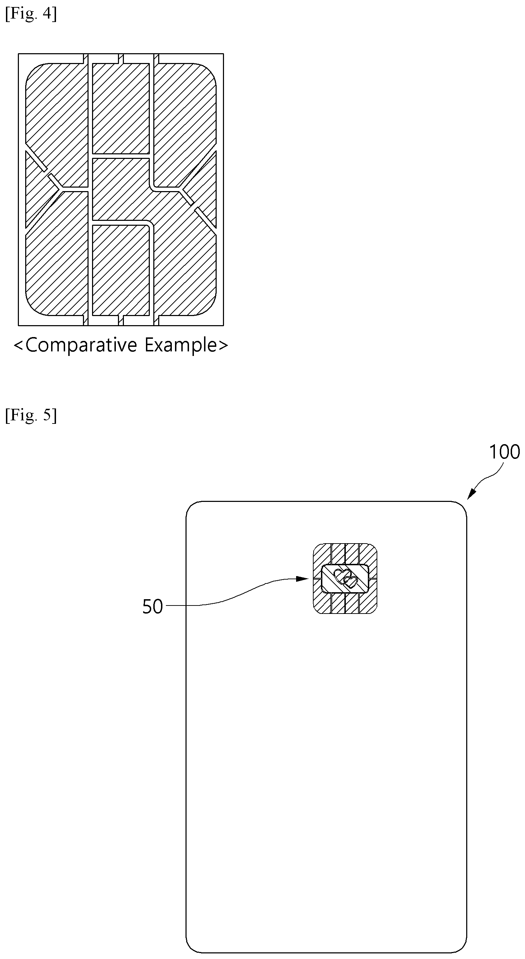

FIG. 4 is a photo image showing the contact surface of an electric circuit according to a comparative example.

Referring to FIG. 4, the contact surface of the electric circuit according to the comparative example may have gold color as a single color. In the case of the electric circuit applied to the existing smart card, the surface color is standardized or limited to gold color or silver color due to manufacturing method restrictions. The color of the surface portion (contact surface) of the electric circuit is standardized to a single color, which makes it difficult to advance color or create emotional and design functions/values. In relation to this, it is difficult to meet various needs of consumers (users). However, according to an example embodiment of the present invention, it is possible to implement the electric circuit for smart card capable of creating an emotional/design added value with at least two types of surface colors, breaking away from the monotony of the existing metallic contact surface color.

FIG. 5 is an image showing a smart card 100 that applies an electric circuit 50 for smart card according to an example embodiment of the present invention.

Referring to FIG. 5, as described above, the smart card 100 according to an example embodiment of the present invention may include the electric circuit 50 having at least two types of metallic surface colors exposed to the contact surface. The electric circuit 50 may include a pattern area, and various designs (including characters) may be applied to the pattern area. The electric circuit 50 having at least two types of metallic surface colors may be embedded and installed in a predetermined area of a plastic card body. Here, the contact surface of the electric circuit 50 may be exposed to the outside of the smart card 100.

According to example embodiments of the present invention, it is possible to implement the electric circuit for smart card that may diversify/advance the color of the metallic contact surface, which has been limited due to the existing technical constraint, into at least two types, may improve aesthetics (visual characteristics) by enabling application of various designs (patterns), and may also easily secure excellent electrical characteristics. According to example embodiments, it is possible to create a visual added value by adding an emotional function to an electrical communication function of a wireless communication chip card. It is possible to break away from the monotony of the existing metallic contact surface color and to create an emotional/design added value with two or more types of surface colors. When applying the electric circuit for smart card according to the example embodiments, it is possible to manufacture the smart card that may meet various needs of consumers (users).

Hereinafter, a manufacturing method of an electric circuit for smart card according to an example embodiment of the present invention is described.

The manufacturing method of the electric circuit for smart card according to the example embodiment of the present invention may include preparing a device structure for the electric circuit provided with a first circuit pattern that includes a conductor on a substrate; and forming a metallic contact layer on the substrate to cover the first circuit pattern, and having at least two types of metallic surface colors exposed to the contact surface of the electric circuit. The metallic contact layer may be configured to include a first color layer formed of a first material to have a first color and a second color layer formed of a second material to have a second color different from the first color, and at least a portion of the first color and at least a portion of the second color may be exposed to the contact surface.

According to an example embodiment, the first color layer may be a first plating layer, and the second color layer may be a second plating layer. The first and second color layers maybe plating layers (metal layers) formed using a plating method. As a non-limiting example, the first color layer may be formed on the surface of the first circuit pattern using a plating method. The second color layer may be formed on a portion of the first color layer using a plating method.

The first and second color layers may include different metals. In detail, for example, the first color layer may include one of Au, Pd, Ag, and Ni, and the second color layer may include another one of Au, Pd, Ag, and Ni. The first color layer may be formed of one of Au, Pd, Ag, and Ni, and the second color layer may be formed of another one of Au, Pd, Ag, and Ni. Here, Au may produce gold color, and Pd and Ag may produce silver color. However, specific materials of the first and second color layers are not limited to the above and may be variously modified depending on cases. Also, colors represented by the first and second color layers may be more diverse in addition to silver and gold colors.

According to an example embodiment, a portion of the first color layer may be covered by the second color layer, and may not be exposed to the contact surface. In this case, the portion of the first color layer covered by the second color layer may serve as a plating seed to form the second color layer. However, the example embodiment of the present invention is not limited thereto. That is, the entire first color layer may not be covered by the second color layer, and the first and second color layers may be separately formed. In this case, the entire first color layer may be exposed to the contact surface, and the entire second color layer may also be exposed to the contact surface.

Also, according to an example embodiment, the first circuit pattern may be provided on the first surface of the substrate, and the device structure may further include a second circuit pattern provided on the second surface of the substrate. The second surface of the substrate may be a surface that faces (opposite to) the first surface. The manufacturing method of the electric circuit for smart card may further include forming a metallic material layer on the second surface of the substrate to cover the second circuit pattern. The metallic material layer may be a metallic surface layer. According to an example, the metallic material layer may be a plating layer. As a non-limiting example, the metallic material layer may include one of Au, Pd, Ag, and Ni, or may be formed of one of Au, Pd, Ag, and Ni. The second circuit pattern and the metallic material layer may be provided on the bonding surface side of the electric circuit.

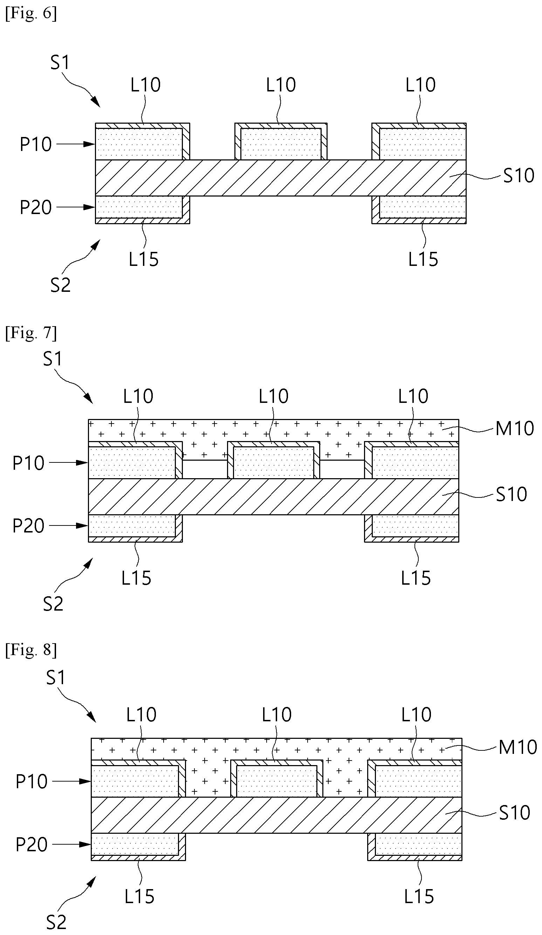

FIGS. 6 to 11 are cross-sectional views for describing an electric circuit for smart card according to an exemplary example embodiment of the present invention.

Referring to FIG. 6, a device structure for electric circuit equipped with the first circuit pattern P10 including a conductor may be prepared on the substrate S10. The first circuit pattern P10 may be provided on the first surface of the substrate S10. The device structure may further include the second circuit pattern P20 provided on the second surface of the substrate S10. The first surface may be one surface of top and bottom surfaces of the substrate S10, and the second surface may be the other surface of top and bottom surfaces of the substrate S10. In the device structure, the surface on which the first circuit pattern P10 is formed may correspond to the contact surface S1 of the electric circuit, and the surface on which the second circuit pattern P20 is formed may correspond to the bonding surface S2 of the electric circuit.

The first color layer L10 may be formed on the first surface of the substrate S10 to cover the first circuit pattern P10. The first color layer L10 may have a first color and may be formed of a first material. The first color layer L10 may be formed on the surface of the first circuit pattern P10 using a plating method. For example, the first color layer L10 may include one of Au, Pd, Ag, and Ni, or may be formed of one of Au, Pd, Ag, and Ni.

Also, the metallic material layer L15 may be formed on the second surface of the substrate S10 to cover the second circuit pattern P20. The metallic material layer L15 may be formed on the surface of the second circuit pattern P20 using a plating method. Therefore, the metallic material layer L15 may be a plating layer. For example, the metallic material layer L15 may include one of Au, Pd, Ag, and Ni, or may be formed of one of Au, Pd, Ag, and Ni. The metallic material layer L15 may be formed of a material different from that of the first color layer L10, and may also be formed of the same material depending on cases.

Referring to FIG. 7, a mask material layer M10 may be formed on the substrate S10 to cover the first color layer L10. The mask material layer M10 may include, for example, photoresist (photosensitive material). Therefore, the mask material layer M10 may be a photoresist layer. The mask material layer M10 may be a type of dry film. Depending on cases, the mask material layer M10 may not completely fill a space between a plurality of pattern portions that constitute the first circuit pattern P10. In this case, the bottom surface of the mask material layer M10 may not be in contact with the surface (the first surface) of the substrate S10, and a gap may be present therebetween.

Referring to FIG. 8, a process of pressing the mask material layer M10 (i.e., pressing process) may be performed. By pressing the mask material layer M10, a gap between the mask material layer M10 and the surface (the first surface) of the substrate S10 may be removed, and the gap between the plurality of pattern portions constituting the first circuit pattern P10 may be completely (or almost completely) filled with a material of the mask material layer M10. The pressing process may be performed using, for example, autoclave. In this case, in the pressing process, a pressure of about 15 to 250 PSI may be applied to the mask material layer M10.

However, the pressing process may be optional. In an operation of FIG. 7, the mask material layer M10 may be formed to completely or substantially fill the space between the plurality of pattern portions that constitute the first circuit pattern P10. In this case, the pressing process may be omitted.

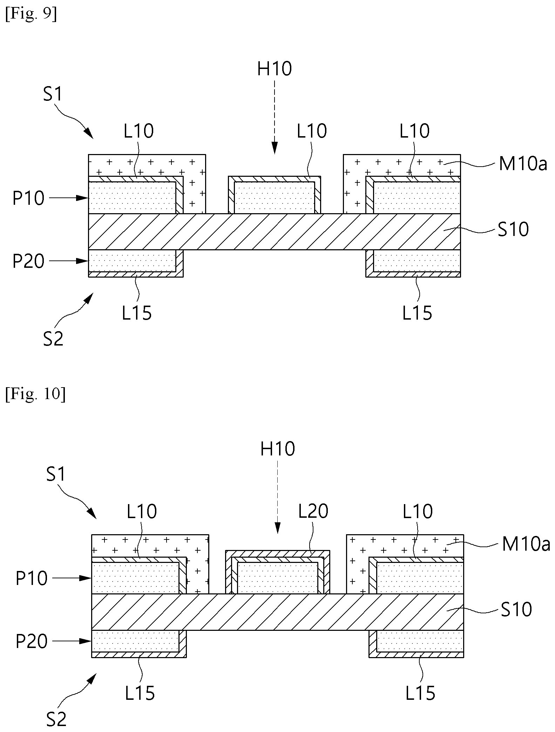

Referring to FIG. 9, a mask pattern M10a with an opening H10 that exposes a portion of the first color layer L10 from the mask material layer M10 may be formed by removing a portion of the mask material layer M10. The patterned mask pattern M10a may be formed from the mask material layer M10 by performing an exposure and development process on the mask material layer M10.

Referring to FIG. 10, the second color layer L20 may be formed on the first color layer L10 exposed by the opening H10. The second color layer L20 may have a second color different from the first color and may be formed of a second material different from the first material. The second color layer L20 may be formed on the surface of the first color layer L10 exposed by the opening H10 using a plating method. For example, the second color layer L20 may include one of Au, Pd, Ag, and Ni, or may be formed of one of Au, Pd, Ag, and Ni. The second color layer L20 may be formed of a material different from that of the first color layer L10, and may represent a color different from that of the first color layer L10.

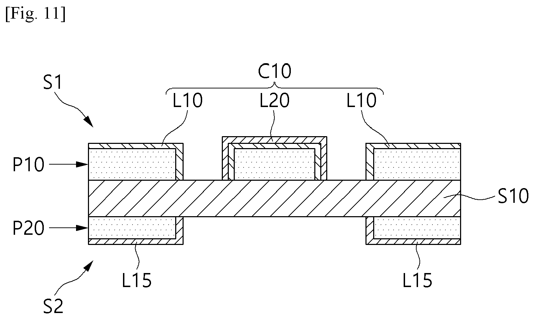

Referring to FIG. 11, the mask pattern M10a may be removed. The mask pattern M10a may be removed using a peeling method or other methods. The first color layer L10 and the second color layer L20 may constitute the metallic contact layer C10. The metallic contact layer C10 may be configured to have at least two types of metallic surface colors exposed to the contact surface S1 of the electric circuit. At least a portion of the first color layer L10 and at least a portion of the second color layer L20 may be exposed to the contact surface S1. The electric circuit structure of FIG. 11 may be the same as the electric circuit structure described with FIG. 1. Therefore, all features described related to the electric circuit in FIG. 1 may be applied to the electric circuit of FIG. 11.

According to an example embodiment of the present invention, as described above with reference to FIGS. 6 to 11, the electric circuit that includes the metallic contact layer C10 having at least two types of metallic surface colors may be manufactured through selective surface plating treatment. Here, a resist material for heterogenous plating treatment may be used. However, the manufacturing method of the electric circuit according to an example embodiment of the present invention may be variously modified without being limited to the description made above with reference to FIGS. 6 to 11.

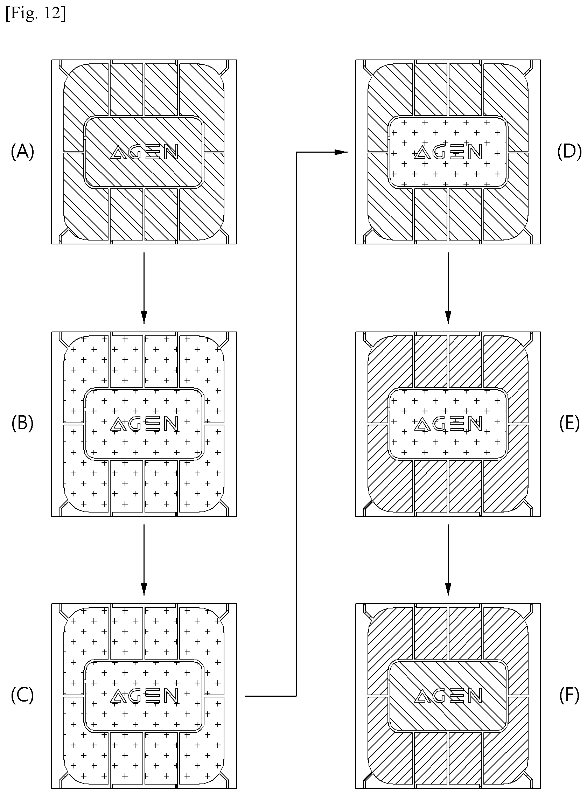

FIG. 12 illustrates a view for describing a manufacturing method of an electric circuit for smart card according to an exemplary example embodiment of the present invention.

(A) to (F) of FIG. 12 show images of the contact surface of the electric circuit at each manufacturing stage. (A) of FIG. 12 may correspond to the operation of FIG. 6, (B) may correspond to the operation of FIG. 7, and (C) may correspond to the operation of FIG. 8. (D) of FIG. 12 may correspond to the operation of FIG. 9, (E) may correspond to the operation of FIG. 10, and (F) may correspond to the operation of FIG. 11. However, the manufacturing process shown in FIG. 12 and process results are provided as examples only, and may be variously modified.

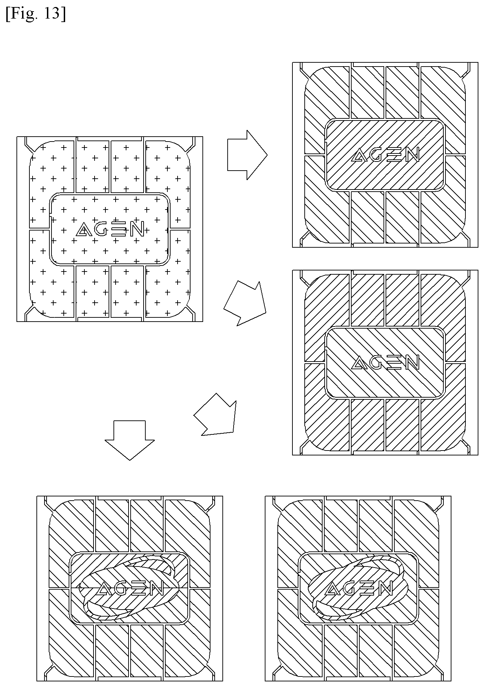

FIG. 13 illustrates a view for describing a manufacturing method of an electric circuit for smart card according to an example embodiment of the present invention.

Referring to FIG. 13, various results may be acquired from the same device structure (starting device structure) for electric circuit, according to a specific process method. By applying at least two types of colors and various designs/patterns, it is possible to implement a unique and emotional electric circuit that may meet various needs of consumers, and a smart card including the same.

According to example embodiments of the present invention as described above, it is possible to implement an electric circuit for smart card that may diversify/advance the color of the metallic contact surface, which has been limited due to the existing technical constraint, into at least two types, may improve aesthetics (visual characteristics) by enabling application of various designs (patterns), and may also easily secure excellent electrical characteristics. According to example embodiments, a visual added value may be created by adding an emotional function to an electrical communication function of a wireless communication chip card. It is possible to create an emotional/design added value by breaking away from the monotony of the existing color and design and by applying at least two types of surface colors and various designs. It is possible to diversify the color of the communication module pad surface of an IC chip card and to implement a unique design. When applying the electric circuit for smart card according to such example embodiments, it is possible to manufacture the smart card that may meet various needs of consumers (users).

Although exemplary example embodiments of the present invention are disclosed herein and specific terms are used, they are used in general meaning to easily explain technical content of the present invention and to help understanding of the present invention and are not construed to limit the scope of the present invention. In addition to the example embodiments disclosed herein, it will be apparent to one of ordinary skill in the art to which the present invention pertains that other modifications may be made based on the technical spirit of the present invention. For example, one of ordinary skill in the art may be appreciated that the electric circuit for smart card according to example embodiments described above with reference to FIGS. 1 to 3 and FIGS. 5 to 13, the manufacturing method thereof, and the smart card including the electric circuit may be variously modified. In detail, for example, although the electric circuit is simply illustrated, it may be seen that, in reality, it may have a more complex and sophisticated circuit structure. It will be appreciated that a detailed structure and a manufacturing method of the electric circuit may be variously modified and the application field of the electric circuit may also variously change. Also, it will be appreciated that three or more types of metallic surface colors may be applied to the contact surface of the electric circuit and, in this case, a metallic contact layer may further include at least one additional color layer (e.g., additional plating layer) having at least one different color. Therefore, the scope of the present invention should not be determined by the example embodiments described above, but should be determined by the technical spirit stated in the claims.

## Claims

1. An electric circuit for smart card, comprising:
a substrate;
a first circuit pattern provided on the substrate and including a conductor; and
a metallic contact layer formed on the substrate to cover the first circuit pattern, and configured to have at least two types of metallic surface colors exposed to the contact surface of the electric circuit,
wherein the metallic contact layer includes a first color layer formed of a first material to have a first color and a second color layer formed of a second material to have a second color different from the first color, and at least a portion of the first color layer and at least a portion of the second color layer are exposed to the contact surface.

2. The electric circuit for smart card of claim 1, wherein the first color layer is a first plating layer, and
the second color layer is a second plating layer.

3. The electric circuit for smart card of claim 1, wherein the first color layer includes one of Au, Pd, Ag, and Ni, and
the second color layer includes another one of Au, Pd, Ag, and Ni.

4. The electric circuit for smart card of claim 1, wherein a plurality of contact pad areas are defined on the contact surface of the electric circuit, and
at least two of the plurality of contact pad areas have different metallic surface colors, or different metallic surface colors are applied within one contact pad area among the plurality of contact pad areas.

5. The electric circuit for smart card of claim 1, wherein a plurality of contact pad areas and a pattern area are defined on the contact surface of the electric circuit, the pattern area includes at least one of a character, a number, a symbol, and a picture design, and
the at least two types of metallic surface colors are applied to at least one of the plurality of contact pad areas and the pattern area.

6. The electric circuit for smart card of claim 5, wherein the plurality of contact pad areas are provided to surround the pattern area.

7. The electric circuit for smart card of claim 1, wherein a portion of the first color layer is covered by the second color layer and is not exposed to the contact surface.

8. The electric circuit for smart card of claim 1, wherein the first circuit pattern is in at least one structure of a Cu/Ni/Au stacked structure, a Cu/Ni/Au/Pd stacked structure, a Cu/Ni/Pd/Au stacked structure, a Cu/Ni/Pd stacked structure, a Cu/Pd stacked structure, a Cu/Ni stacked structure, a Cu/Au stacked structure, and a Cu single layer structure.

9. The electric circuit for smart card of claim 1, wherein the first circuit pattern is provided on a first surface of the substrate, and
the electric circuit for smart card further comprises:
a second circuit pattern provided on a second surface of the substrate; and
a plating layer formed on the second surface of the substrate to cover the second circuit pattern.

10. A smart card comprising the electric circuit for smart card stated in one of claims 1 to 9.

11. A manufacturing method of an electric circuit for smart card, comprising:
preparing a device structure for the electric circuit provided with a first circuit pattern that includes a conductor on a substrate; and
forming a metallic contact layer on the substrate to cover the first circuit pattern, and having at least two types of metallic surface colors exposed to the contact surface of the electric circuit,
wherein the metallic contact layer is configured to include a first color layer formed of a first material to have a first color and a second color layer formed of a second material to have a second color different from the first color, and at least a portion of the first color and at least a portion of the second color are exposed to the contact surface.

12. The method of claim 11, wherein the first color layer is a first plating layer, and
the second color layer is a second plating layer.

13. The method of claim 11, wherein the forming of the metallic contact layer comprises:
forming the first color layer on the substrate to cover the first circuit pattern using a plating method;
forming a mask material layer on the substrate to cover the first color layer;
forming a mask pattern with an opening that exposes a portion of the first color layer from the mask material layer by removing a portion of the mask material layer;
forming the second color layer on the first color layer exposed by the opening using a plating method; and
removing the mask pattern.

14. The method of claim 11, wherein a portion of the first color layer is covered by the second color layer, and is not exposed to the contact surface.

15. The method of claim 11, wherein the first circuit pattern is provided on a first surface of the substrate, and
the device structure further includes a second circuit pattern provided on a second surface of the substrate, and
the manufacturing method of the electric circuit for smart card further comprises forming a plating layer on the second surface of the substrate to cover the second circuit pattern.
